# EUROPEAN PATENT APPLICATION

(11) **EP 2 717 478 A1**
(43) Date of publication of application: **09.04.2014**
(21) Application number: 12792156.7
(22) Date of filing: 29.05.2012
(51) Int. Cl.: H03M 13/27, H04J 99/00, H04L 1/00

(54) **INTERLEAVING APPARATUS AND WIRELESS COMMUNICATION SYSTEM**

(30) Priority: 03.06.2011 JP 2011125201
(71) Applicant: KDDI Corporation, Tokyo 163-8003 (JP)
(72) Inventor: MATSUMOTO Tomoko, Fujimino-shi Saitama 356-8502 (JP); HATAKAWA Yasuyuki, Fujimino-shi Saitama 356-8502 (JP); KITAYABU Toru, Fujimino-shi Saitama 356-8502 (JP); KONISHI Satoshi, Fujimino-shi Saitama 356-8502 (JP)
(74) Representative: Treeby, Philip David William
(86) International application number: PCT/JP2012/063742
(87) International publication number: WO 2012/165424

(57) **Abstract**

An interleaving apparatus includes an interleaver for concurrently sorting bits of input data according to the predetermined interleave pattern; a switch including an input terminal supplied with an input signal subject to an interleave process, an input terminal supplied with a signal output from the interleaver, an output terminal for outputting an output signal, representing the result of interleaving completed on the input signal, and an output terminal for outputting a signal input to the interleaver, thus switching connection between the input terminals and the output terminals; and a controller for controlling the switch to use the interleaver once or repeatedly use it multiple times in response to each of interleave patterns.

## Description

### TECHNICAL FIELD

The present invention relates to an interleaving apparatus via interleave division multiple access (IDMA) and a wireless communication system.

The present application claims priority on Japanese Patent Application No. 2011-125201 filed June 3, 2011, the entire content of which is incorporated herein by reference.

### BACKGROUND ART

Multiple accesses are considered as one technology for efficiently using limited frequency resources via a plurality of users in wireless communication systems. The frequency division multiple access (FDMA), the time division multiple access (TDMA), and the code division multiple access (CDMA) are conventionally known as primary multiple accesses.

Recently, the interleave division multiple access (IDMA) has been considered. The IDMA identifies users by use of different interleavers for individual users; hence, it can be regarded as a method using interleavers replacing user identification codes via CDMA. However, the IDMA does not exhibit direct orthogonality between users' signals at reception times of signals. For this reason, it utilizes different interleavers (i.e. interleave patterns) for individual users so as to repeat multiuser reception, thus achieving pseudo orthogonality to separate users' signals.

As a method of designing an interleaver for use in the IDMA, for example, Non-Patent Literature Document 1 discloses a method to randomly generate interleave patterns for interleavers. Patent Literature Document 1 discloses a method to successively generate a plurality of interleavers by combining common interleavers commonly shared by all users, delay taps, and interleave patterns for individual users.

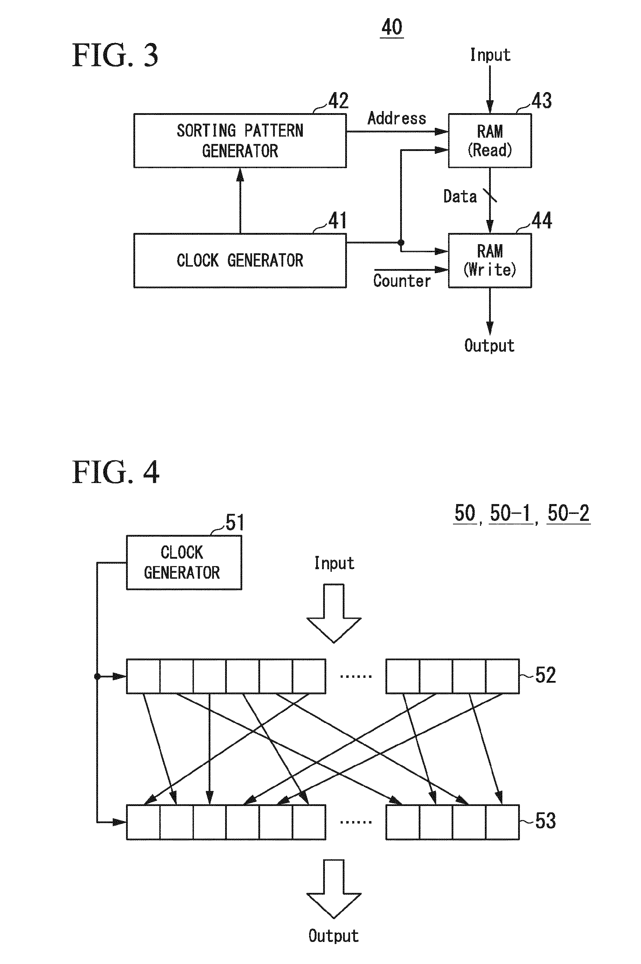

Fig. 3 is a configuration diagram of a conventional interleaver 40. The interleaver 40 includes a clock generator 41, a sorting pattern generator 42, and random access memories (RAMs) 43, 44. It is possible to generate plenty of interleave patterns by changing addresses input to the RAMs 43, 44 in synchronism with a clock signal output from the clock generator 41.

Fig. 4 is a configuration diagram of a conventional interleaver 50. The interleaver 50 includes a clock generator 51 and registers 52, 53. Herein, the registers 52 and 53 are connected in a bit-by-bit manner according to a predetermined interleave pattern. In the interleaver 50, the bits of input data are forwarded from the register 52 to the register 53 in synchronism with a clock signal output from the clock generator 51 and then sorted according to an interleave pattern.

### CITATION LIST

### PATENT LITERATURE DOCUMENT

Patent Literature Document 1: Japanese Patent Application Publication No. 2007-135201

### NON-PATENT LITERATURE DOCUMENT

Non-Patent Literature Document 1:I. Pupeza, A. Kavcic and L. Ping, "Efficient Generation of Interleavers for IDMA" in proc. ICC vol. 4, June 2006

### SUMMARY OF INVENTION

### TECHNICAL PROBLEM

In the conventional interleaver 40 shown in Fig. 3, the number of bits processed in each clock cycle is limited to the length of input/output data in the RAM (normally, one bit), wherein plenty of clock pulses is needed to complete an interleave process for one input data (whose data length is longer than the length of input/output data in the RAM); this may increase a delay in an interleave process.

The conventional interleaver 50 shown in Fig. 5 is able to complete an interleave process in one clock cycle; hence, it reduces a delay in an interleave process. When a plurality of interleave patterns is needed, however, it is necessary to prepare plural pairs of registers 52, 53, the number of which is identical to the number of interleave patterns. The IDMA needs a plurality of different interleave patterns for the number of users estimated; hence, this may increase circuit scales.

The present invention is made in consideration of the aforementioned circumstances, wherein it is an object of the invention to provide a wireless communication system and an interleaving apparatus which is able to reduce delays in interleave processes of interleavers via IDMA while preventing an increased circuit scale for each interleaver.

### SOLUTION TO PROBLEM

To solve the foregoing problem, an interleaving apparatus of the present invention is directed to an interleaving apparatus via interleave division multiple access, including a first interleaver which is configured to concurrently sort bits of input data according to a first interleave pattern; a switch including a first input terminal supplied with an input signal subject to an interleave process, a second input terminal supplied with a signal output from the first interleaver, a first output terminal for outputting an interleaved signal completing interleaving on the input signal, and a second output terminal for outputting a signal supplied to the first interleaver, thus switching connection between the first and second input terminals and the first and second output terminals; and a controller which is configured to control the switch to connect the second input terminal to the first output terminal or the second output terminal in response to each of interleave patterns, thus using the first interleaver once or repeatedly using it multiple times.

The interleaving apparatus of the present invention may further include a second interleaver which is configured to concurrently sort bits of input data according to a second interleave pattern. In this case, the switch includes a third input terminal supplied with a signal output from the second interleaver and a third output terminal for outputting a signal supplied to the second interleaver, wherein the controller controls the switch so as to connect the second input terminal to the first, second, or third output terminal while connecting the third input terminal to the first, second, or third output terminal.

A wireless communication system of the present invention is directed to a wireless communication system via IDMA which includes the interleaving apparatus installed in a terminal or a base station.

In the wireless communication system of the present invention, when the number of terminals concurrently multiplexed via IDMA is smaller than the total number of interleave patterns generated by the base station, it is preferable to initially allocate an interleave pattern, which is generated in a short processing time, to a terminal.

In the wireless communication system of the present invention, it is preferable to allocate an interleave pattern whose interleave process is completed in a short processing time to a terminal having high reception quality.

In the wireless communication system of the present invention, it is preferable to allocate an interleave pattern whose interleave process is completed in a short processing time to a terminal which is given high priority because of a high signal-to-noise ratio before multiuser reception processing and a high received signal strength indicator and then to a user which is given priority because of a high signal-to-noise ratio.

### ADVANTAGEOUS EFFECTS OF INVENTION

According to the present invention, it is possible to reduce delays in processing of interleavers via IDMA while preventing an increased circuit scale for each interleaver.

### BRIEF DESCRIPTION OF DRAWINGS

Fig. 1 is a block diagram showing the configuration of an interleaving apparatus via IDMA according to one embodiment of the present invention.
Fig. 2 is a block diagram of a wireless communication system via IDMA according to one embodiment of the present invention.
Fig. 3 is a block diagram showing a conventional example of an interleaver.
Fig. 4 is a block diagram showing another example of an interleaver.

### DESCRIPTION OF EMBODIMENT

Hereinafter, the embodiments of the present invention will be described with reference to the drawings.

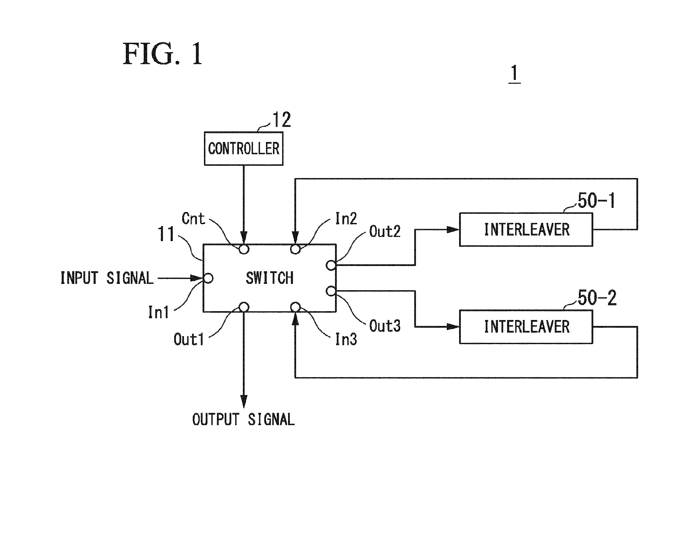

Fig. 1 is a block diagram showing the configuration of an interleaving apparatus 1 via IDMA according to one embodiment of the present invention. In Fig. 1, the interleaving apparatus 1 includes interleavers 50-1, 50-2, a switch 11, and a controller 12. The basic configurations of the interleavers 50-1, 50-2 are identical to that of the interleaver 50 shown in Fig. 4.

As shown in Fig. 4, the bits of input data in the interleavers 50-1, 50-2 are forwarded from the register 52 to the register 53 in synchronism with a clock signal output from the clock generator 51 and then concurrently sorted according to the predetermined interleave pattern. Each of the interleavers 50-1, 50-2 completes an interleave process in one clock cycle. In this connection, it is possible to arbitrarily determine a connection between the registers 52 and 53 (i.e. the predetermined interleave pattern).

In the present embodiment, the interleaving apparatus 1 includes two interleavers 50-1, 50-2. To include a plurality of interleavers 50, it is possible to share the clock generator 51 shown in Fig. 4 in common. The interleaving apparatus 1 may include a single interleaver or three or more interleavers unless its circuit scale is increased excessively.

The switch 11 includes three input terminals In1, In2, In3, three output terminals Out1, Out2, Out3, and a control terminal Cnt. An input signal subjected to an interleave process is input to the input terminal In1. An output signal representing the result of an interleave process on an input signal is output from the output terminal Out1.

A signal output from the output terminal Out2 is input to the interleaver 50-1. A signal output from the interleaver 50-1 is input to the input terminal In2. A signal output from the output terminal Out3 is input to the interleaver 50-2. A signal output from the interleaver 50-2 is input to the input terminal In3.

The controller 12 applies a control signal to the control terminal Cnt. The switch 11 switches connections between the input terminals In1, In2, In3 and the output terminals Out1, Out2, Out3 in accordance with the control signal input to the control terminal Cnt.

It is possible to generate a plurality of interleave patterns by way of the interleavers 50-1, 50-2 since the controller 12 switches connections between the input terminals In1, In2, In3 and the output terminals Out1, Out2, Out3 in the switch 11.

For example, it is possible to generate a plurality of interleave patterns by solely using the interleaver 50-1 once or by repeatedly using it multiple times. An external device supplies an input signal to the input terminal In1. The controller 12 controls the switch 11 so as to connect the input terminal In1 to the output terminal Out2, thus supplying an input signal to the interleaver 50-1. The input signal is subjected to an interleave process in the interleaver 50-1 according to the predetermined interleave pattern. The interleaved output data is supplied to the input terminal In2 of the switch 11. To carry out the process of the interleaver 50-1 once, the controller 12 connects the input terminal In2 to the output terminal Out1, thus outputting the once-interleaved output data from the output terminal Out1 as an output signal. To carry out the process of the interleaver 50-1 multiple times, the controller 12 connects the input terminal In2 to the output terminal Out2, thus supplying the once-interleaved output data to the interleaver 50-1 again. The supplied output data is subjected to the interleave process in the interleaver 50-1 according to the predetermined interleave pattern again and then supplied to the input terminal In2. To carry out the process of the interleaver 50-1 two times, the controller 12 connects the input terminal In2 to the output terminal Out1, thus outputting an output signal from an output terminal. To further carry out the process of the interleaver 50-1, the controller 12 connects the input terminal In2 to the output terminal Out2, thus supplying the output data to the interleaver 50-1 again.

Alternatively, it is possible to generate a plurality of interleave patterns by solely using the interleaver 50-2 once or multiple times. In this case, the controller 12 connects the input terminal In1 to the output terminal Out3 so as to supply an input signal, supplied to the input terminal In1, to the interleaver 50-2. The input signal is subjected to an interleave process in the interleaver 50-2 according to the predetermined interleave pattern. The interleaved output data is supplied to the input terminal In3 of the switch 11. To carry out the process of the interleaver 50-2 once, the controller 12 connects the input terminal In3 to the output terminal Out1 so as to output the once-interleaved output data from the output terminal Out1 as an output signal. To carry out the process of the interleaver 50-2 multiple times, the controller 12 connects the input terminal In3 to the output terminal Out3 so as to supply the once-interleaved output data to the interleaver 50-2 again. The supplied output data is subjected to an interleave process in the interleaver 50-2 according to the predetermined interleave pattern again and then supplied to the input terminal In3. To carry out the process of the interleaver 50-2 twice, the controller 12 connects the input terminal In3 to the output terminal Out1 so as to output the output signal from the output terminal Out1. To further carry out the process of the interleaver 50-2, the controller 12 connects the input terminal In3 to the output terminal Out3 so as to supply the output data to the interleaver 50-2 again.

Moreover, it is possible to generate a plurality of interleave patterns by arbitrarily combining the interleavers 50-1 and 50-2. For example, the interleave process of the interleaver 50-2 after the interleave process of the interleaver 50-1 will be explained. In this case, the controller 12 connects the input terminal In1 to the output terminal Out2 so as to supply the input signal, supplied to the input terminal In1, to the interleaver 50-1. The input signal is subjected to the interleave process in the interleaver 50-1 according to the predetermined interleave pattern. The interleaved output data is supplied to the input terminal In2 of the switch 11. Next, the controller 12 connects the input terminal In2 to the output terminal Out3 so as to supply the output data, which is interleaved by the interleaver 50-1, to the interleaver 50-2. The supplied output data is subjected to the interleave process in the interleaver 50-2 according to the predetermined interleave pattern and then supplied to the input terminal In3. The controller 12 connects the input terminal In3 to the output terminal Out1. Thus, the output data, which is successively subjected to the interleave processes in the interleavers 50-1 and 50-2, is output from the output terminal Out1 as an output signal.

As described above, the interleaving apparatus 1 is able to perform interleave processes according to a plurality of interleave patterns.

The present embodiment repeatedly utilizes the interleaver 50-1 and/or the interleaver 50-2, which completes an interleave process in one clock cycle, so as to generate a plurality of interleave patterns while reducing the processing time needed for each interleave process. Alternatively, it is possible to reduce the number of interleavers 50, thus it is possible to prevent the increased circuit scale of each interleaver.

The number of interleave patterns which can be generated depends on the number of interleavers 50 and the maximum delay time allowed for completion of each interleave process. Using M as the number of interleavers 50 and L (i.e. the number of clock cycles) as the maximum allowable delay time, it is possible to generate a plurality of interleave patterns, the number of which is expressed as "1+M¹+M²+...+M^{L}". The M interleavers 50 and the maximum allowable delay time L are determined based on the hardware scale allowed for a communication device via the IDMA. To prioritize the processing time, for example, it is possible to adopt the configuration which is designed to increase the number of interleavers 50 while reducing a delay time.

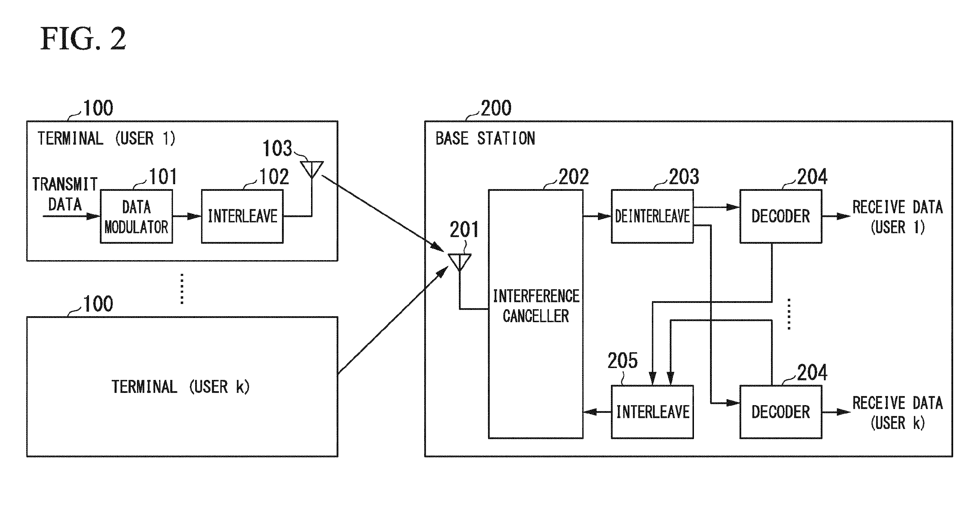

Fig. 2 is a diagrammatical configuration diagram of a wireless communication system via IDMA according to the present embodiment. In Fig. 2, K (i.e. User 1 to User K (where K denotes a natural number)) terminals 100 are connected to a base station 200 via IDMA. In the terminal 100 of User N (where N is a natural number ranging from 1 to K), a data modulator 101 modulates transmission data. An interleave part 102 interleaves the transmission data, output from the data modulator 101, according to an interleave pattern unique to User N. The interleaved transmission data is wirelessly transmitted via an antenna 103.

The base station 200 receives transmission data, which is wirelessly transmitted from each of User 1 to User K, via an antenna 201. An interference canceller 202 carries out an interference cancelling process on the received data. A deinterleave part 203 deinterleaves the received data, output from the interference canceller 202, for each of User 1 to User K. The deinterleave process utilizes a deinterleave pattern against an interleave pattern unique to each user. With respect to User N, a deinterleave process is performed using a deinterleave pattern unique to User N.

A decoder 204 is arranged in correspondence with each of User 1 to User K. The received data output from the interference canceller 202 is deinterleaved using a deinterleave pattern for User N, and then the deinterleaved received data is input to the decoder 203 for User N. The decoder 204 decodes the received data input thereto. The decoded received data is output to an interleave part 205.

The received data output from the decoder 204 for each of User 1 to User K is input to the interleave part 205. The interleave part 205 interleaves the received data, input from the decoder 204 for each of User 1 to User K, with respect to each of User 1 to User K. The interleave process uses an interleave pattern unique to each user. Therefore, an interleave process is performed using an interleave pattern unique to User N with respect to User N. The interleaved received data is output to the interference canceller 202. The interference canceller 202 carries out an interference canceling process on the received data input from the interleave part 205, thus outputting the processed received data to the deinterleave part 203.

The base station 200 repeats a series of the foregoing interference canceling process, the deinterleave process, and the decoding process multiple times, thus outputting the received data for each of User 1 to User K.

In the wireless communication system via IDMA shown in Fig. 2, the interleaving apparatus 1 shown in Fig. 1 is used for the deinterleave part 203 and the interleave part 205 in the base station 200. The interleaving apparatus 1 shown in Fig. 1 can be used for the interleave part 102 of the terminal 100 as well.

In the interleave part 205 of the base station 200, i.e. the interleaving apparatus 1 of Fig. 1, the controller 12 controls the switch 11 to generate K interleave patterns unique to User 1 to User K. In the deinterleave part 203 of the base station 200, i.e. the interleaving apparatus 1 of Fig. 1, the controller 12 controls the switch 11 to generate K deinterleave patterns unique to User 1 to User K.

When an interleave pattern allocated to each user is changed in the interleave part 102 of the terminal 100, i.e. the interleaving apparatus 1 of Fig. 1, the controller 12 controls the switch 11 to generate the changed interleave pattern. For example, when the base station 200 connected to each user is changed, there is a possibility that an interleave pattern allocated to each user may be changed correspondingly.

As a method of notifying an allocated interleave pattern from the base station 200 to the terminal 100, for example, there are provided two methods, i.e. Method 1 and Method 2, as follows.

### (Method 1)

The base station 200 notifies the terminal 100 of User N with a permutation of an index, which the terminal 100 of User N applies to the interleaver 50, and the interleaver in use, via a control channel. For example, five interleavers 50 are assigned interleaver identifiers of "INT001", "INT002", "INT003", "INT004", and "INT005". The base station 200 notifies the terminal 100 of User N of an index "#1" for "INT002" and an index "#2" for "INT004" which are indexes assigned to the interleavers 50 in use, i.e. "INT002" and "INT004", as well as a permutation of the interleavers 50 in use, i.e. "#1, #1, #2". In the terminal 100 of User N, the controller 12 of the interleaving apparatus 1 controls the switch 11 so as to sequentially use the interleavers 50 in an order of "INT002" at first, "INT002" next, and "INT004" at last, thus completing interleave processes.

### (Method 2)

The base station 200 shares the indexes of the interleavers 50 in connection with the terminals 100 for User 1 to User K in advance. The base station 200 notifies the terminal 100 of User N of a permutation of the interleavers 50 for use in the terminal 100 of User N via a control channel. For example, five interleavers 50 are assigned interleaver identifiers of "INT001", "INT002", "INT003", "INT004", and "INT005" with an index "#1" for "INT001", an index "#2" for "INT002", an index "#3" for "INT003", an index "#4" for "INT004", and an index "#5" for "INT005". The base station 200 notifies the terminal 100 of User N of a permutation of the interleavers 50 in use, i.e. "#1, #1, #2". In the terminal 100 of User N, the controller 12 of the interleaving apparatus 1 controls the switch 11 so as to sequentially use the interleavers 50 in an order of "INT001" at first, "INT001" next, and "INT002" at last, thus completing interleave processes.

When the number "K" of users which can be concurrently multiplexed via IDMA is smaller than the total number of interleave patterns which can be generated by the base station 200, it is preferable to sequentially allocate interleave patterns, started with an interleave pattern whose interleave process can be completed in a short processing time, to the terminals 100 of User 1 to User K.

To change interleave patterns depending on the reception quality of each terminal among the terminals 100 of User 1 to User K, it is preferable to allocate an interleave pattern whose interleave process can be completed in a short processing time to the terminal 100 having high reception quality. For example, an interleave pattern whose interleave process can be completed in a short processing time is allocated to the terminal 100 which is given high priority because of a high signal-to-noise ratio (SNR) before multiuser reception processing and a high received signal strength indicator (RSSI). Next, an interleave pattern whose interleave process can be completed in a short processing time is allocated to the terminal 100 which is given priority because of a high SNR. In the isolation processing via IDMA, it is possible to rapidly complete an isolation process on the terminal 100 with high reception quality, thus rapidly eliminating an interference with other terminals 100; hence, it is possible to shorten the entire processing time in the isolation processing via IDMA.

Hereinabove, the foregoing embodiment of the present invention is described with reference to the drawings, whereas specific configurations are not necessarily limited to the foregoing embodiment, which may embrace design changes without departing from the subject matter of the present invention.

For example, the interleavers 50 can be configured using register wiring or FPGA (Field Programmable Gate Array).

As a method of selecting an interleave pattern allocated to the terminal 100 among all available interleave patterns, for example, it is possible to determine a pair of interleavers 50 and its sequence in use based on conversion information which is produced by converting an identifier (i.e. a terminal ID) unique to the terminal 100 by way of a hash function.

When the terminal 100 makes initial access to the base station 200, it is impossible to exchange information regarding interleave patterns which are used between the terminal 100 and the base station 200. For this reason, it is necessary to determine a default interleave pattern in advance, and therefore a communication is carried out using the default interleave pattern in initial access.

For the purpose of distinguishing interleave patterns among different cells, it is possible to combine an interleave pattern for each cell with an interleave pattern for each user.

### INDUSTRIAL APPLICABILITY

The present invention is applicable to any wireless communication system via IDMA so as to increase the speed of the interleave processing while reducing the circuit scale for the interleaver processing.

### REFERENCE SIGNS LIST

1 ... interleaving apparatus
11... switch
12 ... controller
50 ... interleaver
51 ... clock generator
52, 53 ... register
100 ... terminal
101 ... data modulator
102, 205 ... interleave part
103,201 ... antenna
202 ... interference canceller
203 ... deinterleave part
204 ... decoder

## Claims

1. An interleaving apparatus via interleave division multiple access, comprising:
a first interleaver which is configured to concurrently sort bits of input data according to a first interleave pattern;
a switch including a first input terminal supplied with an input signal subject to an interleave process, a second input terminal supplied with a signal output from the first interleaver, a first output terminal for outputting an interleaved signal completing interleaving on the input signal, and a second output terminal for outputting a signal supplied to the first interleaver, thus switching over connection between the first and second input terminals and the first and second output terminals; and
a controller which is configured to control the switch to connect the second input terminal to the first output terminal or the second output terminal in response to each of interleave patterns, thus using the first interleaver once or repeatedly using the first interleaver multiple times.

2. The interleaving apparatus according to claim 1, further comprising a second interleaver which is configured to concurrently sort the bits of input data according to a second interleave pattern,
wherein the switch includes a third input terminal supplied with a signal output from the second interleaver and a third output terminal for outputting a signal supplied to the second interleaver, and
wherein the controller controls the switch so as to connect the second input terminal to the first, second, or third output terminal while connecting the third input terminal to the first, second, or third output terminal.

3. A wireless communication system via IDMA comprising the interleaving apparatus according to claim 1 or 2 installed in a terminal or a base station.

4. The wireless communication system according to claim 3, wherein, when a number of terminals concurrently multiplexed via IDMA is smaller than a total number of interleave patterns generated by the base station, an interleave pattern which is generated in a short processing time is initially allocated to a terminal.

5. The wireless communication system according to claim 3 or 4, wherein an interleave pattern whose interleave process is completed in a short processing time is allocated to a terminal having high reception quality.

6. The wireless communication system according to claim 5, wherein an interleave pattern whose interleave process is completed in a short processing time is allocated to a terminal which is given high priority because of a high signal-to-noise ratio before multiuser reception processing and a high received signal strength indicator and then to a user which is given priority because of a high signal-to-noise ratio.
